# EUROPEAN PATENT APPLICATION

(11) **EP 4 083 708 A1**
(43) Date of publication of application: **02.11.2022**
(21) Application number: 21171130.4
(22) Date of filing: 29.04.2021
(51) Int. Cl.: G03F 7/20, G02B 5/08

(54) **MIRROR SYSTEM**

(71) Applicant: ASML Netherlands B.V., 5500 AH Veldhoven (NL)
(72) Inventor: KLUGKIST, Joost André, 5500 AH Veldhoven (NL); BOS, Koen, Martin, Willem Jan, 5500 AH Veldhoven (NL); ANAND, Anirudh, 5500 AH Veldhoven (NL)
(74) Representative: ASML Netherlands B.V.

(57) **Abstract**

A mirror system (200), comprising a mirror (202) and a waveguide (206) comprising: an input (208) configured to receive a light beam (216) from a light source (214) and one or more light splitting elements (212A) configured to split the light beam into a plurality of beams and direct each of said beams to a respective one of a plurality of outputs (210A), each output arranged to direct the respective beam to a respective one of a plurality of areas (220A) of the mirror.

## Description

### FIELD

The present invention relates to a mirror system and a method of controlling deformations of a mirror of such a mirror system. In particular, but not exclusively, the mirror system can be used in a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The projection system which is used to image the pattern from a patterning device onto the substrate will induce some aberrations in the wavefront of the projected image. During the projection of the pattern onto the substrate, the projection system will heat up, and this will cause the imaging properties of the projection system to drift. In EUV lithography, this phenomenon is called mirror heating. Although mirrors in the projection system are optimized for EUV radiation transmission, a significant part of EUV (but also out-of-band) energy is absorbed in the mirrors and transformed into heat. This heating causes thermal stresses in the material of the mirrors leading to deformations of the optical surfaces. These deformations finally cause aberrations in the projection system causing imaging errors. In addition, the heating, either directly or indirectly, may cause thermal stresses in the material of other components, such as lenses, substrate clamps, patterning devices (i.e. reticles or masks) or patterning device clamps.

It is an object of the invention to provide a method for correcting aberrations which obviates or mitigates one or more problems associated with the prior art.

### SUMMARY

In an example described herein there is a mirror system, comprising a mirror, and a waveguide comprising an input configured to receive a light beam from a light source and one or more light splitting elements configured to split the light beam into a plurality of beams and direct each of said beams to a respective one of a plurality of outputs, each light splitting element arranged to direct the respective beam to a respective one of a plurality of areas of the mirror.

In use, mirrors may experience deformations due to radiation incident upon (and hence reflected by) the mirror. Mirror deformations may lead to disadvantageous optical properties of reflected radiation, for example deformations may induce optical aberrations in the reflected radiation. The mirror system described herein can be used to illuminate at least one of a plurality of areas of the mirror and hence heat these areas. By illuminating these areas, the mirror system can be used to control deformations. For example, by illuminating these areas, the mirror system may be used to reduce deformations experienced by the mirror. Additionally or alternatively, by illuminating these areas, the mirror system may be used to induce deformations on the mirror, for example to modify the optical properties of reflected radiation. By illuminating a plurality of areas of the mirror, better control of deformations may be achieved compared to illuminating only a single area of the mirror.

Using this mirror system, a plurality of areas can be irradiated using only a single light source. Such a light source may be separated from the mirror. A mirror system of this arrangement may exhibit an increased lifetime as there are few or no complex components (e.g. light sources), which may break and hence require replacement or repair, integrated into the mirror system. A mirror system of this arrangement may be implemented as a smaller (e.g. requiring less volume) mirror system compared to other mirror systems with illumination means because the waveguide allows the light source to be separated from the mirror.

The light may comprise any type of radiation, for example infra-red radiation or broadband radiation. The plurality of areas may be separate, for example adjacent areas may not overlap. Alternatively, at least some of the plurality of areas may overlap.

While, in use, each beam may illuminate an area, it may also illuminate a volume of the mirror (wherein the area forms a portion of the volume). Volume illumination may occur when the light beam travels through a partially absorbing material between a light splitting element and its respective area such that a fraction of the energy in the beam is absorbed by (and hence illuminates) successive planes within a volume. The illuminated area may comprise any of the planes within the illuminated volume, for example it may comprise the plane which absorbs the greatest fraction of energy compared to the other planes in the volume. Furthermore, it should be understood that directing a beam to an area of the mirror may result in a volume of the mirror being heated due to diffusion of heat through the mirror.

The waveguide may contain a medium. The medium may have a first refractive index which is greater than a second refractive index of a material surrounding the waveguide. In this way, light travelling through the waveguide is generally contained within and guided by the waveguide. Alternatively, the waveguide may have a reflective coating on walls of the waveguide such that light is generally contained within and guided by the waveguide.

The mirror may have a front side defined by a radiation facing surface and a back side, and wherein the plurality of areas are located on the back side of the mirror.

The radiation facing surface is arranged to receive radiation which requires reflecting by the mirror. The back side may comprise portions of the mirror which are not the radiation facing surface. The back side may refer to portions of the mirror which, in use, do not receive radiation which requires reflecting. The back side may be considered the portions of the mirror 'behind' the reflective face. When referring to the plurality of areas being located on the back side of the mirror, the plurality of areas may be on a surface of the backside of the mirror or within one of the portions of the back side of the mirror. That is, the plurality of areas may be on or in the back side of the mirror.

In this arrangement, the light splitting elements are arranged to direct beams of light to the back side of the mirror. Therefore, the mirror system heats the back side of the mirror. The back side of the mirror may be particularly sensitive to deformations. For example, the back side and front side may comprise a material with a zero-crossing temperature which is approximately equivalent, but the back side is typically at a lower temperature compared to the front side when radiation is incident upon the front side, resulting in increased expansion or contraction of the back side compared to the front side. As such, it may be beneficial to reduce unwanted deformations on the back side of the mirror. Furthermore, due to the sensitivity of the backside to deformations, it may be easier to induce desired deformations with of the mirror by heating the back side. Therefore, desired deformations may be induced with a reduced power of light compared to other heating methods, for example those that heat the front side of the mirror.

The mirror may comprise a first layer and a second layer, the first layer comprising the radiation facing surface. The first layer may be referred to as a reflective layer. The second layer may be referred to as a mirror body. The reflective layer and mirror body may be adjacent at a mirror-reflective interface. The first layer may be located adjacent to the front side of the mirror. The back side of the mirror may comprise the second layer.

The plurality of areas may be located at an interface between the first layer and the second layer. The interface may be referred to as a mirror-reflective interface. The interface may define a boundary between the front side and the back side of the mirror. In this arrangement, the mirror system can illuminate, and hence control deformations of, a back side of the first layer. Such an arrangement may provide control of deformations on the radiation receiving surface. The plurality of outputs of the waveguide may extend through the second layer such that each beam is directed directly to the interface. Alternatively, the beams may travel through at least a portion of the second layer. The wavelength of light provided to the waveguide and the optical properties of the second layer may be selected to permit transmittance of the beams through at least a portion of the second layer.

The second layer may further comprise a light receiving layer upon which the plurality of areas are located. The light receiving layer may comprise a material with different properties to other portions of the mirror. Beneficially, the light receiving layer may be selected to have properties that allow improved control over the deformation of the mirror. For example, the light receiving layer may comprise an ultra low expansion material. Alternatively, the light receiving layer may have a higher expansion coefficient compared to other portions of the mirror. The light receiving layer may have a different zero crossing temperature compared to other portions of the mirror. The light receiving layer may have increased absorption compared to other portions of the mirror. The light receiving layer may have an increased thermal conductivity compared to other portions of the mirror.

The light receiving layer may be located on an outer surface of the second layer, for example a back surface of the mirror which is distal to the radiation receiving surface of the mirror. Alternatively, the light receiving layer may be located internally within the second layer. The light receiving layer may be located proximal to the first layer, for example it may be located at the interface between the first and second layers. When the light receiving layer is internal (within the mirror i.e. internally within the second layer or at the interface between the first and second layer), the plurality of outputs of the waveguide may extend through the second layer to the light receiving layer. Alternatively, the beams may travel through at least a portion of the second layer before being incident upon the light receiving layer. The wavelength of light provided to the waveguide and the optical properties of the second layer may be selected to permit transmittance of the beams through at least a portion of the second layer. The light receiving layer may be referred to as a third layer.

The mirror may comprise the waveguide. That is, the waveguide is located within the mirror. Locating the waveguide within the mirror may enable the footprint (e.g. volume) of the mirror system to be reduced while still providing deformation control. When the mirror comprises a first layer and a second layer as described above, the second layer may comprise the waveguide.

The waveguide may be external to the mirror.

The mirror system may further comprise a mirror holder, the mirror holder comprising the waveguide.

The light splitting elements may be arranged such that the plurality of areas form a pattern. The pattern may be selected to provide illumination, and hence deformation, in a desired manner (e.g. in a desired area or areas of the mirror system). The pattern may correspond to a particular use of the mirror system, for example the pattern may correspond to a profile of a radiation beam to be received by the mirror.

In many applications, mirrors are not uniformly irradiated by radiation which they are positioned to reflect. The mirror may be arranged to receive patterned radiation. Such patterned light may cause particular deformations of the mirror. By forming a specific pattern with the plurality of areas, the particular deformations caused by patterned radiation may be compensated for. For example, a mirror may receive and reflect radiation which has a dipole beam profile. In such instances, it may be beneficial to selectively illuminate portions of the mirror in a pattern which correspond to areas of high or low intensity within the beam profile. The pattern may be selected to induce a modification of the optical properties of reflected radiation. Illuminating the mirror in a specific pattern may induce a particular deformation configured to modify the reflected radiation. The reflected radiation may comprise a pattern or wavefront arrangement dependent on the initial beam profile and induced deformations.

The light splitting elements may be passive. For example, the light splitting elements may be fixed in place such that no actuation is required to direct light. Rather, the light is directed to the outputs (and hence to the areas of the mirror) simply by being provided to the input. By being passive, the light splitting elements are less likely to become damaged or require maintenance and hence the mirror system may have an increased lifetime.

At least one of the light splitting elements may comprise means of separating light with a specific optical property from the light beam.

The optical property may comprise, for example, a range of wavelengths. In other words, a light splitting element may comprise means to separate light with a specific range of wavelengths from the light beam. This specific range of wavelengths is then directed, as a one of the plurality of beams, to a respective output associated with the light splitting element. Additionally or alternatively to a range of wavelengths, the light splitting elements may be used to separate light with another optical property, for example with a specific polarization.

By providing means for separating light with a specific optical property, the plurality of areas may be selectively illuminated by controlling the optical properties of the light beam received by the waveguide.

A first light splitting element may comprise a first dichroic beamsplitter operable to direct a first range of wavelengths to a first output. A second light splitting element may comprise a second dichroic beamsplitter operable to direct a second range of wavelengths different to the first range of wavelengths to a second output.

In this arrangement, the first dichroic beamsplitter directs light with a first range of wavelengths to a first area of the mirror and the second dichroic beamsplitter directs light with a second range of wavelengths to a second area of the mirror. By receiving (at the input of the waveguide) light which contains light in the first range of wavelengths and light in the second range of wavelengths, both the first and second areas are illuminated. By receiving (at the input of the waveguide) light which contains only light in the first range of wavelengths or light in the second range of wavelengths, only the first or second area is illuminated. As such, the use of first and second dichroic beamsplitters may enable selective illumination of different areas of the mirror.

The mirror system may further comprise additional dichroic beamsplitters which may direct light in the first and/or second range of wavelengths and/or in additional ranges of wavelengths. For example, each output may have an associated dichroic beamsplitter operable to reflect a range of wavelength which is generally distinct from the range of wavelengths reflected by the other dichroic beamsplitters. In such an arrangement, each area of the mirror which is able to be illuminated may be selectively illuminated by selecting the wavelengths of light received by the input of the waveguide. In this way, pixelated control of mirror illumination may be achieved.

The mirror system may comprise multiple first dichroic beamsplitters and multiple second dichroic beamsplitters. The first dichroic beamsplitters may be arranged such that a first plurality of areas of the plurality of areas form a first pattern. The second dichroic beamsplitters may be arranged such that a second plurality of areas of the plurality of areas form a second pattern. By arranging the outputs and dichroic beamsplitters in this way, different patterns of illumination may be achieved by selecting the wavelengths of light received at the input of the waveguide.

At least one light splitting element may further comprise means to modify its respective beam. The modification may comprise a form of focusing or defocusing. As such, the light splitting element may further comprise a focusing or defocusing element, for example a lens, microlens array, diffusor, diffractive optical element. The modification may comprise a shaping of the beam. As such, the light splitting element may further comprise means to shape the beam, for example the light splitting element may be shaped (e.g. bent).

The waveguide may be curved. A curved waveguide may be selected in combination with a curved mirror. A curved waveguide may enable more complex patterns to be formed compared to only using linear beam delivery means.

The mirror system may further comprise means for heating the radiation facing surface. The means for heating the radiation facing surface may provide pre-heating for the radiation facing surface, for example prior to or during the radiation facing surface receiving radiation. Such means for heating may be referred to as a pre-heating system. The waveguide can be provided in combination with the pre-heating system so as to provide complementary heating to the mirror. Complementary heating may comprise heating specific areas which are not being illuminated by the pre-heating system and/or areas which are not receiving radiation. By illuminating (and hence heating) areas which are not being illuminated or receiving radiation, the temperature of the entire mirror can be kept substantially the same (or at least temperature differences between different areas are reduced).

The mirror system may further comprise means for decoupling the thermal properties of the front side and back side. The decoupling means may comprise a cooling liquid (e.g. water) in a cooling channel between the front side and back side. In this arrangement, a pre-heating system may heat the front side of the mirror and the waveguide may provide heating of the back side of the mirror independently to the pre-heating system.

The mirror system may comprise multiple waveguides. The multiple waveguides may comprise a first waveguide configured to enable illumination of a first plurality of areas of the mirror and a second waveguide configured to enable illumination of a second plurality of areas of the mirror.

The mirror system may further comprise means for decoupling thermal properties of a first waveguide of the multiple waveguides and a second waveguide of the multiple waveguides. The decoupling means may comprise a cooling liquid (e.g. water) in a cooling channel between the first and second waveguides. In this arrangement, each waveguide may provide heating independently to the other waveguide.

The mirror may comprise an EUV mirror. That is, the mirror is configured to reflect EUV radiation. Deformations are particularly prevalent when using EUV radiation, and in particular when high powers of EUV radiation are used. Therefore, the mirror systems described herein are particularly beneficial for use in EUV systems.

The mirror system may further comprise a light source arranged to provide a light beam to the input of the waveguide.

The light source may be configured to selectively control one or more optical properties of light in the light beam. The optical properties may comprise the wavelengths of light in the light beam. For example, the light source may provide a first light beam having a first range of wavelengths for a first duration and a second light beam having a second range of wavelengths for a second duration. The optical properties may comprise one or more polarizations of light in the light beam. The optical properties may comprise an intensity of light.

In another example described herein there is a lithographic apparatus comprising a mirror system as described herein. Deformations of mirrors can negatively affect optical properties of reflected radiation. As such, deformations of mirrors can negatively affect lithographic performance, so control of these deformations is particularly beneficial in lithography.

In another example described herein there is a method of controlling deformations of a mirror using a mirror system described herein. The method comprises selecting one or more optical properties of the light beam so as to selectively illuminate one or more of a plurality of areas of the mirror.

By selecting the one or more optical properties of the beam, one or more of the light splitting elements of the mirror system can be utilized, thereby enabling controlled and selective illumination of areas associated with the one or more light splitting elements.

The optical property may comprise, for example, a range of wavelengths. A first set of one or more light splitting elements may be configured to separate light with a specific range of wavelengths from the light beam. By selecting the optical properties of the light beam such that the light beam contains this specific range of wavelengths, this first set of one or more light splitting elements is utilized, wherein each of the first set of light splitting elements directs a beam with that specific range of wavelengths to a corresponding area of the mirror. By selecting the optical properties of the light beam such that the light beam does not contain this specific range of wavelengths, the first set of one or more light splitting elements is not utilized, so their corresponding areas are not illuminated. The optical properties may comprise one or more polarizations of light in the light beam. The optical properties may comprise an intensity of light.

### BRIEF DESCRIPTION OF THE DRAWINGS

Examples relevant for illustrating the claimed invention will now be described, by way of example only, with reference to the accompanying schematic drawings, in which:
- Figure 1 depicts a lithographic system comprising a lithographic apparatus and a radiation source;
- Figure 2A depicts a mirror system;
- Figure 2B depicts the mirror system of Figure 2A in use;
- Figure 2C depicts a cross-sectional view of the mirror system of Figure 2B in a plane Z;
- Figures 3A and 3B depict mirror systems which utilize curved waveguides;
- Figure 4 depicts a light splitting element with a beam modifying device;
- Figure 5 depicts a mirror system which can be used to selectively illuminate different areas of the mirror;
- Figures 6A-C illustrates a mirror system in which different patterns of areas may be selectively illuminated;
- Figures 7A-C illustrate mirror systems in which the back side of the mirror can be illuminated.

### DETAILED DESCRIPTION

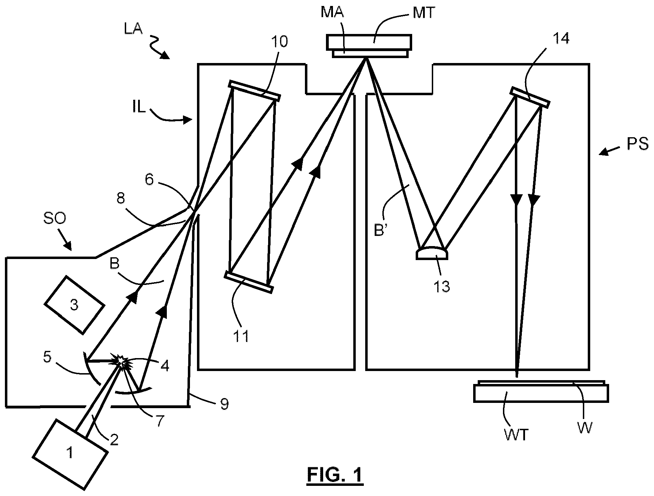

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source or a free electron laser (FEL) or any other radiation source that is capable of generating EUV radiation.

Optical surface deformation may occur in mirrors, for example mirrors in the projection system PS of the EUV lithographic apparatus LA. More generally, surface deformation may occur in components in the EUV lithographic apparatus LA. It will be appreciated that, although the following description generally relates to a mirror system or mirrors in the projection system PS in the EUV lithographic apparatus LA, the methods described are also applicable to other components in the EUV lithographic apparatus LA and other components in other lithographic apparatus, such as a DUV lithographic apparatus. For example, the component may be an optical element, a mirror, a projection system mirror, an illumination system mirror, a lens, a projection system lens, an illumination system lens, a collector.

In a lithographic apparatus LA, incoming electro-magnetic (EM) waves (i.e. EUV radiation) interact with mirror(s) with some of the radiation being reflected and some absorbed. The absorbed radiation is dissipated within the mirror which leads to mirror heating. Heat is conducted within the mirror and thus the mirror temperature changes over time, e.g. increases. The temperature changes cause the mirror to deform which leads to wavefront aberrations. These wavefront aberrations may need to be corrected in the lithographic apparatus LA, for example to improve the imaging performance of the lithographic apparatus LA.

To reduce the deformations causing aberrations in the projection system PS, the mirror material is optimized for minimum deformations using ultra-low expansion (ULE) material. This material exhibits a quadratic expansion relation with temperature, which has almost-zero expansion properties around its design temperature, known as the zero-crossing temperature (ZCT). The mirror front side (the side which the radiation beam B' is incident upon) may be kept as close to this ZCT as possible to minimize deformations. The mirror material may be made of other materials that have a relatively low or very low, coefficient of thermal expansion (CTE), e.g. ZERODUR^{®} or Cordierite.

With increasing EUV radiation source powers, mirror heating becomes an increasing problem in EUV lithographic apparatus LA. Furthermore, some extreme illumination profiles may lead to a problematic amount of heating in a portion of the mirror, despite other areas of the mirror remaining at an acceptable temperature. In such instances the mirrors of the projection optics (e.g. projection system PS) may heat up too much, deform and cause aberrations that cannot be corrected sufficiently. For example, it may not be possible to keep the mirror surface (either the entire surface or a portion thereof) at the ZCT.

To control the deformations in the projection system PS, mirrors are provided with means for heating the mirror (or portions thereof) in a controlled manner. Mirrors which include such means can be referred to as mirror systems. By heating the mirror, a constant heat load can be provided to the mirror. This constant heat load may maintain the mirror at a desired temperature, for example the ZCT, thereby mitigating or eliminating deformation. Additionally or alternatively to mitigating deformations, deformations can be used advantageously. By heating portions of the mirror, deformations can be induced which provide control over the radiation beam (e.g. the wavefront of the radiation beam can be manipulated). As such, the mirror systems may be configured to reduce deformation, induce deformation, or both.

The radiation beam B may be provided with a beam profile which affects the spatial intensity with which a mirror will be illuminated with EUV radiation. A particular beam profile may provide uniform heating to the front side of the mirror. On the other hand, a non-uniform beam profile may provide spatially non-uniform heating to the front side of the mirror. For example, the radiation beam B may be generated using a dipole illumination mode such that certain parts of the mirrors 13, 14 receive little or no EUV radiation. The mirror systems can be used to provide spatially non-uniform heating to the mirror in order to compensate for such non-uniform heating.

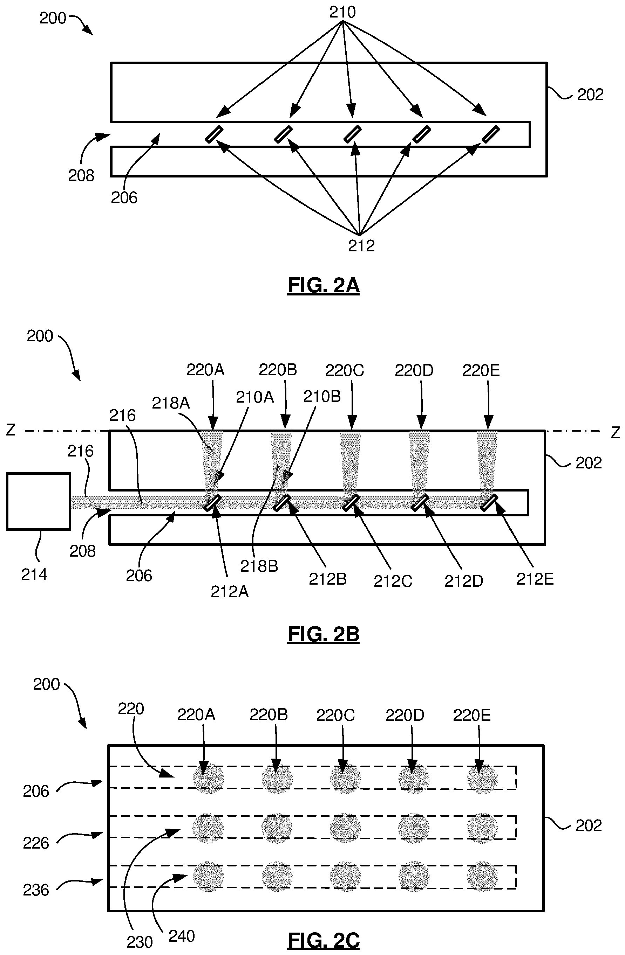

Figure 2A depicts a mirror system 200. The mirror system 200 may be used in a lithographic apparatus of the type shown in Figure 1. The mirror system 200 generally comprises a mirror 202 and an optical waveguide 206 which enables the mirror 202 to be heated through the provision of light. The optical waveguide 206 can be referred to more simply as a waveguide 206.

The waveguide 206 runs through the mirror 202. The waveguide 206 has an input 208 which is configured to receive a light beam from a light source (shown in Figure 2B) and guide the light beam along the waveguide 206. The waveguide 206 takes the form of a channel through the mirror 202. The waveguide 206 comprises a medium having a higher refractive index compared to the refractive index of the material surrounding the waveguide 206, which in this instance is the mirror 202.

The medium forming the waveguide (or a core portion thereof) can comprise a glass, or ceramic, for example Zerodur^{®}. Low expansion materials such as Zerodur^{®} are particularly useful so as to reduce any thermal deformation of the waveguide 206 itself. In a specific example, an optical fiber can be used as the waveguide. In some example arrangements, the waveguide can be provided with a cladding (e.g. an optical fiber cladding) with a lower refractive index than a core portion of the waveguide. In an alternative example, the waveguide can take the form of a cavity which is filled with gas or liquid, vacuum or near vacuum. In this instance, the medium (e.g. gas or vacuum) within the cavity will typically have a lower refractive index than material surrounding the waveguide so additional means are required to contain the light within the waveguide. In this arrangement, the walls of the cavity are hence provided with a reflective coating, enabling light to be contained (e.g. reflected back into) the waveguide. A waveguide taking the form of a cavity filled with gas, liquid, vacuum or near vacuum may be referred to as a light pipe or light tube. Such a waveguide may be referred to as an 'empty' cavity. The material within the 'empty' cavity may be selected and replaced as desired (for example depending on the environment in which the mirror system 200 is positioned) as there is no solid waveguide core.

Arranged in the waveguide 206 is a plurality of beamsplitters 212 (in this instance, five beamsplitters 212). In use, each of the beamsplitters 212 receives the light beam and separates a portion of the light beam it receives. The separated portions can be referred to as separated beams or, more simply, beams. Each beamsplitter 212 directs the separated portion to a corresponding output 210 of the waveguide 206. Each beamsplitter 212 is associated with a corresponding output 210. Each output 210 is associated with a position at which a portion of the light beam may exit the waveguide 206. The outputs 210 may take any form in order to provide a portion of the wall of the waveguide 206 through which light may exit. Generally, the waveguide 206 is designed so as to permit propagation of light along the waveguide 206 (e.g. in one dimension) with minimal loss of energy from the waveguide 206 (e.g. in other dimensions). However, the waveguide 206 is designed to enable energy loss through the outputs 210 so as to permit the separated beams to exit. For example, the outputs 210 may take the form of windows in the wall of the waveguide 206. Alternatively, the outputs 210 may take the form of gaps in the wall of the waveguide 206. Alternatively, the wavelength of light provided by the light source and the material of the wall of the waveguide 206 may be selected such that the light may be transmitted through the wall of the waveguide 206. Alternatively, the permission of light through the wall of the waveguide 206 may be dictated at least partially based on the laws of total internal reflection. That is, the separated beam directed by a beamsplitter is incident to the wall at an angle of incidence smaller than the critical angle and, as such, the separated beam is not significantly reflected at the wall.

Figure 2B depicts the mirror system of Figure 2A in use. In use, a light source 214 is arranged such that a light beam 216 from the light source can be received by the input 208 of the waveguide 206. The light beam 216 propagates along the waveguide 206 and reaches a first beamsplitter 212A. The first beamsplitter 212A separates a portion of the light beam 216 to form a first beam 218A and directs the first beam 218A towards a first output 210A. The remaining portion of the light beam 216 continues propagating along the waveguide 206.

The first beam 218A illuminates an area 220A of the mirror 202. As light from the beam 218A is absorbed by the mirror 202, it transfers energy in the form of heat to the mirror 202. Therefore, the beam 218A heats the area 220A of the mirror 202.

The remaining portion of the light beam 216 propagates along the waveguide until it reaches the second beamsplitter 212B. The second beamsplitter 212B separates a second portion of the light beam 216 to form a second beam 218B and directs the second beam 218B towards a second output 210B, thus illuminating and heating a second area 220B of the mirror.

The remaining portion of the light beam 216 continues to propagate along the waveguide, interacting with a third, fourth and fifth beamsplitter 212C, 212D, 212E, respectively, and illuminating (and thus heating) a third, fourth and fifth area 220C, 220D, 220E of the mirror 202.

Rather than a beamsplitter, any light splitting element may be used. For example, the light splitting element may comprise a simple beamsplitter, partially reflecting mirror, reflector, filter, outcoupler, demultiplexer or diffractive element such as a grating, dichroic mirror, dichroic filter, dichroic beamsplitter, dichroic reflector, grating outcoupler, arrayed waveguide grating, diffraction based spectrometer. This list is non limiting and any optical element operable to split a light beam into multiple (e.g. 2 or more) portions may be used.

Figure 2C depicts a cross-sectional view of the mirror system of Figure 2B in a plane Z. The presence of the waveguide 206, which is not located in the plane Z, is indicated by a dashed line. In this view, the plurality of areas 220A-E of the mirror 202 form a row of areas 220. Their positioning generally follows the shape of the waveguide 206; that is, as the waveguide 206 is generally linear, the illuminated areas 220A-E are arranged linearly.

The mirror system 200 of Figure 2C has, in addition to the (first) waveguide 206, a second and third waveguide 226, 236. These waveguides 226, 236 are comparable to the first waveguide 206 depicted in Figures 2A and 2B and described above. That is, each of the second and third waveguide 226, 236 comprise a plurality of light splitting elements (not shown) and enable illumination of a plurality of areas of the mirror. The presence of the second and third waveguides 226, 236, which are not located in the plane Z, are indicated by a dashed line.

The plurality of areas illuminated by the second and third waveguides 226, 236 are illustrated in Figure 2C and can be seen as two more rows of illuminated areas 230, 240. The rows 220, 230, 240 run generally parallel as, in the illustrated arrangement, the waveguides 206, 226, 236 run generally parallel. As such, the areas 220, 230, 240 form an array of areas which may be illuminated by providing light to each of the waveguides 206, 226, 236.

The location of each area (e.g. areas 220A-E) is determined based on the configuration and arrangement of its corresponding beamsplitter (e.g. 212A-E). That is, the beamsplitters are each arranged to direct their corresponding separated beam to a corresponding selected area. By arranging a beamsplitter (e.g. beamsplitter 212A) at a different angle with respect the waveguide 206, the location of the area (e.g. area 220A) it is configured to illuminate may be moved.

The arrangement of the plurality of areas 220, 230, 240 can be described as a pattern. In the example illustrated in Figure 2A-C, the plurality of areas 220, 230, 240 form a regularly spaced array of areas. That is, the plurality of areas 220, 230, 240 are uniformly spaced. In other arrangements the plurality of areas may be spaced differently. In particular, a pattern may be selected which corresponds to a particular use of the mirror. The pattern may be selected dependent on the type of radiation which the mirror is expected to receive, for example the beam profile of the radiation. That is, the beam profile may be considered a pattern within the radiation beam, and the pattern of the plurality of areas can be arranged correspondingly.

For example, if the mirror is to be irradiated by radiation with a non-uniform beam profile, the plurality of areas may be arranged in a pattern which generally corresponds to the spatial intensity profile of the beam profile. More areas may be arranged at portions of the mirror which, in use, receive little or no radiation. Such an arrangement can be used to cause additional heating in the portions which receive little or no radiation and bring the temperature of these portions closer to the temperature of portions of the mirror which receive a high or higher intensity of radiation. In a specific example, if the mirror is to be irradiated with radiation with a dipole beam profile, the areas can be arranged in a pattern which corresponds to the dipole spatial intensity profile, or an inverse of the dipole spatial intensity profile.

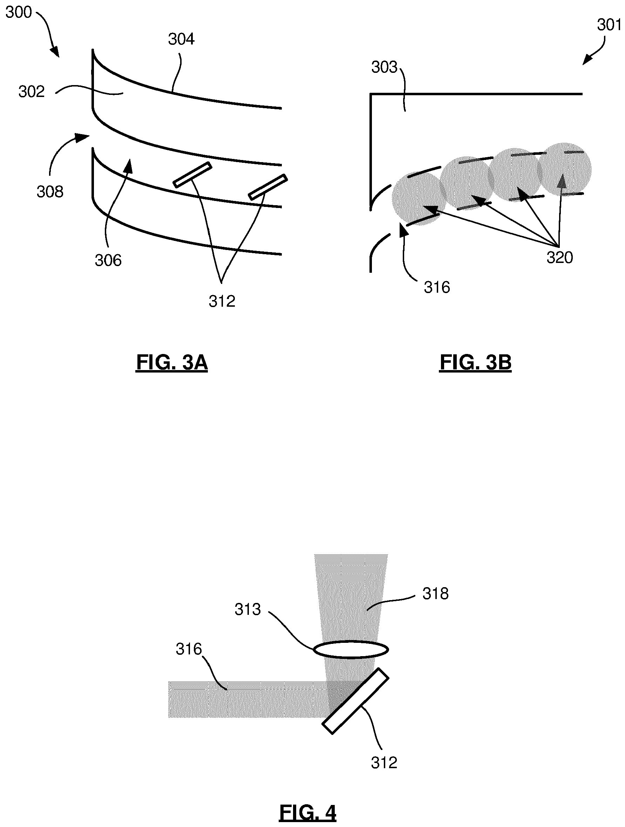

In order to attain different patterns, the shape and arrangement of the waveguides can also be selected. Figure 2C shows an arrangement of waveguides where the waveguides are linear in shape and arranged generally parallel to one another. Figures 3A and 3B illustrate mirror systems which utilize curved waveguides.

Figure 3A depicts a portion of a mirror system 300 comprising a curved mirror 302. Curved mirrors can be used to direct and modify radiation, for example a concave mirror may collect and focus radiation. An example of a curved mirror is the collector 5 of the lithographic apparatus LA shown in Figure 1. The mirror system 300 of Figure 3A has a waveguide 306 which is curved, with a radius of curvature comparable to that of a reflective surface 304 (i.e. radiation facing surface) at the front side of the mirror 302. The waveguide 306 is otherwise comparable to the waveguides 206, 226, 236 depicted in Figures 2A-C and comprises an input 308 configured to receive light from a light source (not shown) and a series of light splitting elements 312.

Figure 3B depicts a portion of a mirror system 301 shown in cross-section, for example in the manner depicted in Figure 2C. The mirror system 301 has a curved waveguide 316, the presence of which is indicated by a dashed line. As a result of the curvature of the waveguide 316, and the arrangement of light splitting elements (not shown) arranged within, the plurality of areas 320 which may be illuminated by light received by the waveguide 316 form a curved row of areas. By using curved waveguides, different patterns of areas may be achieved compared to using linear waveguides. As such, a variety of patterns can be obtained by using curved and/or linear waveguides.

A curved waveguide may still guide light so long as the radius of curvature is not too great. The allowable radius of curvature will depend on the optical properties of the waveguide (e.g. the refractive index of the material within the waveguide and the refractive index of the material surrounding the waveguide) as well as the properties of the light itself (e.g. the wavelength).

The areas 320 depicted in Figure 3B overlap with adjacent areas so as to form a continuous section of illuminated areas. This can be achieved by arranging the light splitting elements close to one another, or by modifying the beams (e.g. such that they diverge by an amount great enough to overlap in the plane in which the areas to be illuminated are located).

Figure 4 depicts a light splitting element 312 with a beam modifying device 313. In particular, the beam modifying device is a lens which causes the separated beam 318 (separated from the light beam 316) to diverge. Other beam modifying devices can be used, for example a microlens array, a diffusor, a diffractive optical element, or any other means of modifying a beam of light. Alternatively, the light splitting element itself may be configured so as to modify the beam. For example, a curved light splitting element (e.g. a bent partially reflecting mirror) may be used to both separate a portion of the light beam into a separated beam and simultaneously shape the separated beam.

The size of the areas can be selected, for example based upon the size of the light beam received by the waveguide, the size (e.g. diameter) of the waveguide, the size of the light splitting elements, and any modifying devices. The size of the areas can be selected based upon the desired level of deformation control, for example with smaller areas leading to a higher level of control. The size of the areas may be selected in dependence of the optical footprint of the mirror (e.g. the area of the reflective surface). For example, the size of the areas may be between 2 to 100 times smaller than the area of the optical footprint or between 3 to 60 times smaller than the optical footprint. Depending on the thermal conductivity of the mirror material, there may be a lower limit to the size of area which yields improved control, for example because thermal leakage between adjacent areas will occur and therefore fine control of local temperatures is limited by thermal leakage. The size of the area may also be selected in dependence on the thickness of the mirror. A larger mirror thickness may lead to greater thermal leakage. The size of the areas may have a diameter of, for example, less than 5x the thickness of the mirror. In a typical example use, for example in a lithographic apparatus, area sizes of approximately 0.5 - 10 cm may be used..

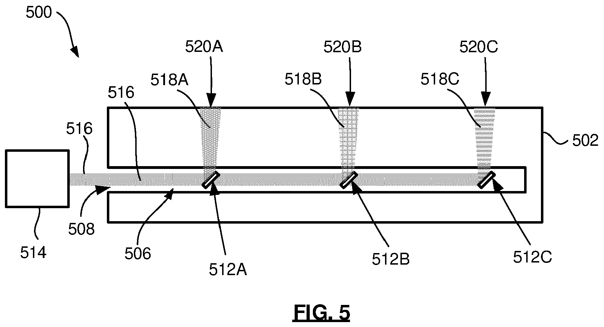

Figure 5 depicts a mirror system 500 which can be used to selectively illuminate different areas of the mirror 502. The mirror system 500 has a mirror 502 through which a waveguide 506 runs. Similar to the waveguides described above, the waveguide 506 has an input 508 which can receive a light beam 516 from a light source 514.

The waveguide 506 also contains a series of dichroic beamsplitters 512A-C. Each of the dichroic beamsplitters 512A-C is operable to separate a portion of the light beam 516 into a separated beam 518A-C, where the separated beam 518A-C comprises radiation with a specific set of wavelengths. For example, the first dichroic beamsplitter 512A may reflect only wavelengths within a sub-band of light having wavelengths between 500 - 600 nm, and permit all other wavelengths. As such, the first dichroic beamsplitter 512A can direct a separated beam 518A to an output, the separated beam 518A having wavelengths within the sub-band of 500 - 600 nm. Therefore, the beam 518A directed by the first dichroic beamsplitter 512A illuminates (and thus heats) a first area 520A of the mirror with light having wavelengths within the range of 500 - 600 nm. Similarly, the second dichroic beamsplitter 512B may reflect only wavelengths within a sub-band of 600 - 700 nm and hence light

(and heat) a second area 520B of the mirror 502 with light having wavelengths within this sub-band of 600 - 700 nm. Similarly, the third dichroic beamsplitter 512C may reflect only wavelengths of over 700 nm and hence light (and heat) a third area 520C of the mirror 502 with light having wavelengths over 700 nm. The dichroic beamsplitters 512A-C may be considered dichroic versions of light splitting elements.

This use of dichroic beamsplitters 512A-C enables different areas of the mirror 502 to be selectively illuminated by selecting the light provided (e.g. by the light source 514) to the input 508 of the waveguide 506. For example, taking the above example where the first beamsplitter 512A reflects wavelengths within the sub-band of 500 - 600 nm. Providing a light beam 516 with having light with wavelengths in this sub-band of 500 - 600 nm effectively switches the first beamsplitter 512A to an 'on' state where it reflects light in this sub-band. However, if no light is provided to the first beamsplitter 512A which it can reflect (i.e. if no light is provided with a wavelength in this sub-band of 500 - 600 nm), the first beamsplitter 512A cannot reflect light and hence is effectively switched 'off'. Therefore, controlling the light source 514 such that the light beam has no light with wavelengths in the sub-band of 500 - 600 nm switches the first beamsplitter 512A 'off'. In the 'on' state, the first beamsplitter 512A enables illumination of the first area 520A. In the 'off' state, the first beamsplitter 512A does not enable illumination of the first area 520A and hence that area remains unilluminated.

The mirror system 500, as well as the mirror systems of previous examples (e.g. the mirror system 200), may be considered passive illumination systems. That is, the light splitting elements (e.g. beamsplitters, dichroic beamsplitters) contain no active parts of mechanisms.

Considering the mirror system 500 of Figure 5, the first beamsplitter 512A itself contain no active parts or mechanisms. The beamsplitter 512A can be switched on and off simply by altering the properties of the light provided to the waveguide. This may increase the lifetime of the mirror system 502 compared to other selective illumination systems as passive systems typically require less (e.g. less frequent) maintenance and replacement. Similarly, the second and third areas 520B, 520C can be selectively illuminated by providing a light beam 516 with light with wavelengths which can be directed by the second and third dichroic beamsplitters 512B, 512C (e.g. in the sub-band of 600 - 700 nm or over 700 nm, respectively). The second and third areas 520B, 520C can be selectively not illuminated by not providing a light beam with these characteristics. That is, by controlling the output of the light source 514, all of the dichroic beamsplitters 512A-C can be passively switched 'on' or 'off'.

The light source 514 used in the embodiment shown in Figure 5 can therefore be configured to selectively control the wavelength of emitted light (i.e. the wavelengths contained in the light beam 516). The light source can provide multiplexed light (i.e. light with multiple wavelengths or wavelength bands). The light source can provide any suitable wavelengths of light as will be known by the skilled person, for example it may be a broadband light source.

The wavelength ranges provided for the dichroic beamsplitters 512A-C are illustrative in nature. In fact, many types of dichroic beamsplitters are available and any ranges of wavelengths (i.e. sub-bands) may be selected. Examples of dichroic beamsplitters include dichroic mirrors, dichroic filters, dichroic reflectors, demultiplexers such as arrayed waveguide gratings or diffraction based spectrometers, or grating outcouplers. This list is non-limiting and any dichroic beamsplitter may be used that is operable to separate light with a specific optical property (e.g. wavelength) from a light beam and direct it as a separated beam. The dichroic beamsplitters may be band-pass, long-pass, short-pass, or any combination thereof. For example, for a light source containing light in the range 800 - 1200 nm may be used in combination with a first short-pass element separating wavelengths below 900 nm, a second long-pass element may be used to separate wavelengths over 1100 nm, and a third reflecting element may be used to direct the remaining portions of the beam (i.e. in the sub-band between 900 - 1100 nm. Furthermore, dichroic beamsplitters may be combined with non-dichroic beamsplitters . For example, a first light splitting element may be a short-pass beamsplitter separating wavelengths below 700 nm, and a second light splitting element may be a simple beamsplitter or mirror, configured to reflect whatever wavelengths (i.e. wavelengths over 700 nm) remain in the light beam. It will be apparent to the skilled person that countless arrangements of light splitting elements are possible.

Furthermore, other properties may be used for selective passive switching. For example, rather than wavelength ranges, light splitting elements may be selected that separate light based upon a different optical property of the light beam, for example polarization. That is, any light splitting element may be used that comprises means of separating light with a specific optical property from the light beam.

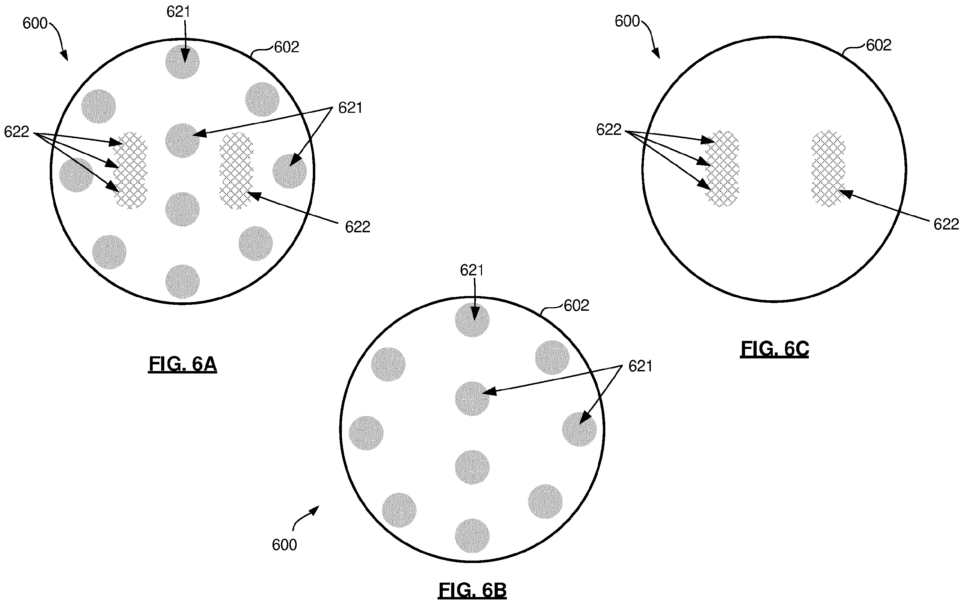

In the example illustrated in Figure 5, each dichroic beamsplitter 512A-C is unique in that it reflects a different wavelength sub-band compared to the other dichroic beamsplitters 512A-C. However, a mirror system may have multiple dichroic beamsplitters which direct light with the same optical properties. An example of such a system is provided below, with reference to Figures 6A-C.

Figures 6A-C illustrates a mirror system 600 in which different patterns of areas may be selectively illuminated through passive switching. The mirror system 600 has a mirror 602 and at least one waveguide (not shown) with dichroic beamsplitters arranged to direct light to a plurality of areas 621, 622 of the mirror 602. The arrangement and configuration of any waveguide(s) is not shown but it should be understood that a large variety of arrangements of waveguide(s) can be used to achieve the illumination patterns shown in Figures 6A-C.

A first set of dichroic beamsplitters (not shown) are arranged to direct beams so as to illuminate a first set of areas 621 (of the plurality of areas). The first set of areas 621 are illustrated arranged in a first pattern. A second set of dichroic beamsplitters (not shown) are arranged to direct beams so as to illuminate a second set of areas 622 (of the plurality of areas). The second set of areas 622 are illustrated arranged in a second pattern. In particular, in the illustrated example the first and second set of areas 621, 622 are associated with areas of low and high intensity, respectively, of a dipole beam profile which can be received by the mirror 602, although the selection of this particular pattern is purely for illustrative purposes and any pattern may be selected. By controlling the optical properties of a light beam provided by a light source (not shown), as described above, the first and second set of dichroic beamsplitters can be switched 'on' or 'off'.

Figure 6A illustrates a situation in which the first and second set of dichroic beamsplitters are switched 'on'. That is, the waveguide(s) are provided with light with optical properties which both the first and second set of dichroic beamsplitters can reflect. As such, all areas (i.e. both the first set of areas 621 and the second set of areas 622) are illuminated.

Figure 6B illustrates a situation in which the first set of dichroic beamsplitters is switched 'on' and the second set of dichroic beamsplitters is switched 'off'. That is, the waveguide(s) are provided with light with optical properties which the first set of dichroic beamsplitters can reflect but which the second set of dichroic beamsplitters does not interact with. As such, only the first set of areas 621 is illuminated.

Figure 6C illustrates a situation in which the second set of dichroic beamsplitters is switched 'on' and the first set of dichroic beamsplitters is switched 'off'. That is, the waveguide(s) are provided with light with optical properties which the second set of dichroic beamsplitters can reflect but which the first set of dichroic beamsplitters does not interact with. As such, only the second set of areas 622 is illuminated.

It should be clear from the illustrated example in Figures 6A-C that this mirror system can enable selective pixelated illumination of the mirror, thereby providing control over deformations in local areas of the mirror.

Selection of the spatial arrangement or pattern of the areas has been described above. The location of the areas on or within the mirror may also be selected. For example, the depth of the areas within the mirror (i.e. the distance travelled by separated beams, e.g. separated beams 218A-C, as they travel from their respective light splitting element before illuminating their respective area) may be controlled.

As described above, mirrors have a front side which is the side which receives radiation (for example the radiation beam B of Figure 1). The front side has a radiation facing surface which is arranged to receive said radiation and reflect it. As such, the radiation facing surface typically forms part of a reflective layer with a reflective surface optimized to reflect radiation. In particular, the reflective layer is optimized to reflect radiation of a particular wavelength (e.g. EUV). For example, the reflective layer may comprise a multilayer coating configured to reflect EUV. The rest of the mirror (for example, a mirror body upon which the radiation facing surface is mounted) is referred to as the back side of the mirror. The back side refers to any portion of the mirror which is not arranged to receive the radiation beam B. It should be understood that, for example due to light leakage, the back side of the mirror may receive a small amount of radiation, but its primary purpose is not that of reflecting the radiation. The back side has, distal to the radiation facing surface, a back face.

In use, radiation is incident upon the front side of the mirror, which causes it to heat up and change temperature. There is some transfer of heat through the mirror (e.g. through the reflective layer) such that the back side heats up. However, the back side of the mirror will typically be at a lower temperature than the front side, with a temperature gradient running from the radiation facing surface to the back face. It has been previously mentioned that it can be desirable to maintain a mirror at a ZCT to avoid deformations. However, due to this difference in temperature between the front side and the back side of the mirror, the back side is typically further from its ZCT compared to the front side in the absence of additional temperature control. As such, arranging the waveguide (and the light splitting elements thereof) such that the plurality of illuminated areas are on the back side of the mirror may be particularly useful. Illuminating the back side of the mirror enables greater control over the temperature of the back side. Furthermore, in situations where the back side is far from its ZCT, relatively small temperature changes lead to a relatively large deformation change, therefore only low powers of light are required to instigate significant deformation control.

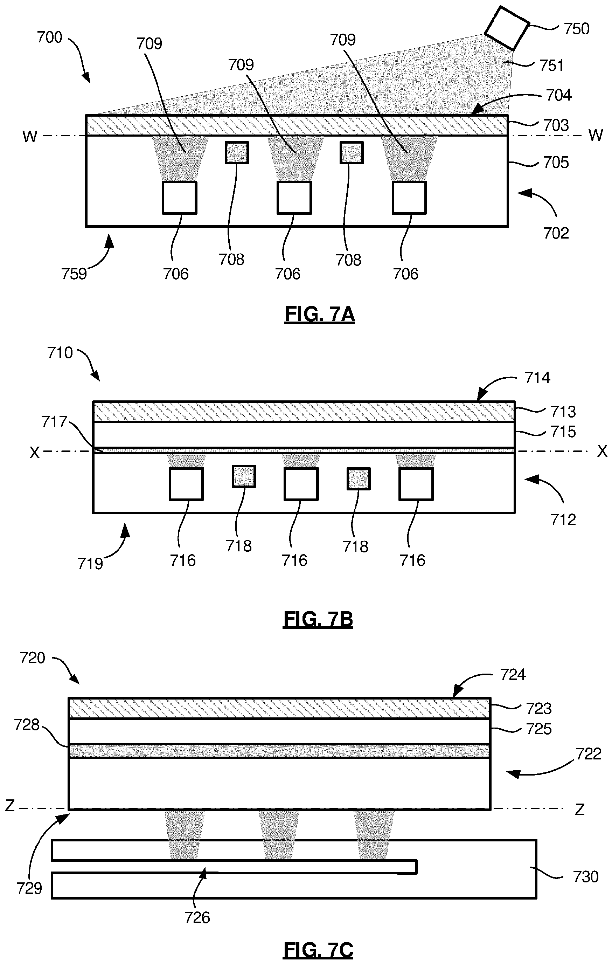

Figures 7A-C illustrate mirror systems in which the back side of the mirror can be illuminated.

Figure 7A depicts a first mirror system 700 which comprises a mirror 702 with a reflective layer 703 (with a reflective surface 704) and a mirror body 705. The reflective layer 703 is adjacent the mirror body 705 and they contact at an interface which may be referred to as a reflective-body interface. The interface lies in a plane W and we refer to the reflective-body interface W herein. The mirror system 700 further comprises three waveguides 706 within the mirror body 702. These waveguides 706 are arranged to enable illumination of a plurality of areas at the reflective-body interface W.

The light beams 709 which are output from the waveguide 706 and propagate to the reflective-body interface W propagate through the mirror body 705. As such, the depth through which the light beams 709 may propagate depends on the optical properties of the mirror body 705 and the wavelength of the light. That is, a wavelength(s) of light can be chosen which have a high transmission through the mirror body 705 but low transmission through the reflective layer 703 such that the majority of the power of the light beams 709 is deposited at the interface W.

As no material is truly 100% transmitting, a fraction of the power in the light beams 709 will be deposited prior to the interface W. As such, it can be said that a volume is being illuminated (and heated) rather than only an area. The effect of volume heating is increased with combinations of wavelength and mirror body optical properties for which the transmissivity is lower.

Also depicted in Figure 7A are a set of cooling channels 708 in the mirror body 705. Cooling channels (e.g. cooling channels 708) are optional and can optionally be implemented in any of the embodiments described herein. The cooling channels 708 are filled with a cooling liquid, although it should be understood that other cooling mechanisms are available. In Figure 7A, the cooling channels 708 at least partially decouple the thermal relationship between the front side and the back side (e.g. a back face 759) of the mirror. Furthermore, the cooling channels 708 at least partially decouple the thermal relationship between the areas/volumes heated by adjacent waveguides 706. The cooling channels 708 in Figure 7A provide decoupling both between the front side and back side and between adjacent waveguides, however in other arrangements a cooling channel may provide decoupling between only the front and back side or between adjacent waveguides, or different cooling channels may be employed for each purpose.

Also depicted in Figure 7A is a mirror pre-heating system 750. The mirror pre-heating system 750 provides a beam 751 of light to the reflective surface 704 at the front side of the mirror 702. Typically, such mirror pre-heating systems are used prior to the mirror receiving radiation so as to pre-heat them to a design temperature (e.g. the ZCT). The mirror systems described herein comprising waveguide(s) can be used as an alternative to, or addition to, such mirror pre-heating systems. Beneficially, the waveguides 706 can provide illumination to the reflective layer 703 at all times, whereas it may not be possible to operate the mirror pre-heating system 750 when the mirror is in use (i.e. receiving radiation). Furthermore, the waveguides 706 can provide finer control over the heating of the mirror compared to the pre-heating system 750. In the arrangement depicted in Figure 7A, both the mirror pre-heating system 750 and the waveguides 706 are used. In particular, the pre-heating system 750 is provided to pre-heat the reflective layer 703, whereas the waveguides 706 can be utilized to control the temperature of the reflective layer 703 when the pre-heating system 750 is not in use (i.e. when the front side of the mirror is receiving radiation).

Figure 7B depicts a second mirror system 710. Comparably to the first mirror system 700 of Figure 7A, the second mirror system 710 comprises a mirror 712 with a reflective layer 713 (with a reflective surface 714) and a mirror body 715. Within the mirror body 715 is a light receiving layer 717 which lies in a plane X. The mirror system 710 further comprises three waveguides 716 within the mirror body 715 which are arranged to enable illumination of a plurality of areas on the light receiving layer 717.

The light receiving layer 717 is optimized for the receipt of light. The exact nature of the optimization will depend on the wavelengths of light used, and the desired deformation reduction or induction.

The light receiving layer 717 may comprise an ultra-low expansion material such that heat can be provided without causing significant additional expansion within the light receiving layer 717. The light receiving layer 717 may comprise a material with a higher expansion coefficient compared to other portions of the mirror, such that significant deformation can be induced with a relatively low power of light. The light receiving layer 717 may have a different zero crossing temperature compared to other portions of the mirror.

The light receiving layer 717 can be modified so as to increase its absorption of light. The absorption may be increased using dopants. Doping may be performed using ionic coloring (using e.g. chromium, nickel, sulfur, ferrous sulfide, manganese oxide). Alternatively, dopants may include carbon, germanium, tin or lead. These dopants in particular may be easily integrated into silicon-based glass as they belong to the same periodic group as silicon. The absorption may additionally or alternatively be increased using colored inclusions, for example titanium oxide or carbon allotropes (e.g. fullerenes, graphene, carbon nanotubes). The absorption may additionally or alternatively be increased by providing a film on the light receiving layer 717, the film having optical properties for increased absorption. An example of such a film is a sputtered amorphous carbon layer. The exact nature of the optimization will depend on the wavelengths of light used, for example because different dopants, impurities and films will affect absorption differently for different wavelengths.

The light receiving layer 717 can be modified so as to increase its thermal conductivity. The thermal conductivity of the light receiving layer 717 may be increased by increasing the thickness of the light receiving layer 717, where the thickness is measured perpendicular to the plane X. The thermal conductivity of the light receiving layer 717 may additionally or alternatively be increased by increasing the concentration of dopants or inclusions such as those described above which increase the optical absorption of the light receiving layer 717. An increased thermal conductivity may increase thermal diffusion in the plane of the light receiving layer 717 (i.e. the plane X), resulting in less heat diffusion perpendicular to the plane X, for example into the mirror body 715. Such an arrangement can result enable a more controlled (e.g. precise) application of heat. When the mirror 712 is in use (e.g. receiving EUV radiation), the mirror 712 heats due to the incident radiation and the light receiving layer 717 may receive some of this heat as the heat diffuses into the mirror 712. An additional benefit of a light receiving layer 717 with increased thermal conductivity is that this heat can be efficiently propagated along the light receiving layer 717 (e.g. in the plane X), leading to a more uniform distribution of heat within the mirror 712. This can yield benefits such as increased thermal imaging contrast and a reduction of out-of-plane thermal blurring. An increased thermal conductivity of the light receiving layer 717 may be particularly beneficial in arrangements where the light receiving layer 717 (i.e. the plane X) is located close to the first layer 713. For example, the light receiving layer may be positioned at the reflective-body interface W illustrated in Figure 7A.

Also depicted in Figure 7B are a set of cooling channels 718 in the mirror body 715. The cooling channels 718 are similar to those depicted in Figure 7A. The cooling channels 718 are located between the light receiving layer 717 and a back face 719 of the mirror system 700 so as to partially decouple the thermal relationship between the light receiving layer 717 and the back face 719 of the mirror. Furthermore, the cooling channels 718 at least partially decouple the thermal relationship between the areas/volumes heated by adjacent waveguides 716.

Figure 7C depicts a third mirror system 720. Comparably to the first and second mirror systems 700, 710 of Figures 7A and 7B, the third mirror system 720 comprises a mirror 722 with a reflective layer 723 (with a reflective surface 724) and a mirror body 725. The third mirror system 720 also comprises a mirror holder 730 which generally holds the mirror 722. The mirror holder 730 can be used for mounting and positioning the mirror 722, for example within a lithographic apparatus such as the lithographic apparatus LA of Figure 1.

The third mirror system 720 has a waveguide 726 which runs through the mirror holder 730. The waveguide 726 is arranged to enable illumination (and hence heating) of a plurality of areas on the back face 729 of the mirror 723. The back face 729 of the mirror lies in a plane Z. As previously mentioned, the back face 729 of the mirror may be far from its ZCT so small changes in temperature on the back face 729 may lead to relative large deformations. A deformation on the back side of the mirror, for example on the back face 729, can lead to deformations on the front side of the mirror, for example on the reflective surface 724. In this arrangement, low powers of input light to the back face 729 can lead to significant deformation control of the reflective surface 724. This arrangement may be particularly useful for inducing deformations on the reflective surface 724, for example for the purpose of wavefront modification.

It is noted that all embodiments described herein can be used for the reduction of deformations (e.g. caused by heating from the received radiation) and/or for the induction of deformation (e.g. so as to modify the wavefront of the radiation).

The third mirror system 720 also has a cooling channel 728 which runs through the mirror body 725. The cooling channel 728 is comparable to those described above, and provides thermal decoupling between the front side and the back side (and in particular between the reflective surface 724 and the back face 729) of the mirror 722.The material of the mirror holder 730 and the wavelength of light can be selected so as to allow propagation of the light through the mirror holder 730.

In another example arrangement, the waveguide may be provided with output waveguides such that the light may travel through a medium with a lower absorption than the absorption of the mirror holder 730. For example, the waveguide may comprise a main channel which furcates at or around a light splitting element into an output waveguide and a continuing main channel. The output waveguides may comprise the same or similar medium to the main channel of the waveguide.. That is, the refractive index of the medium in the output waveguides may be higher than the refractive index of the mirror holder such that the light is guided. Alternatively, the output waveguide may be 'empty' and have a coating designed to reflect light back into the waveguide such that the light is guided.

The plurality of areas may comprise any number of areas greater than one, e.g. two areas or twenty areas. As the splitting elements are passively switchable, depending on the optical properties of the light provided to the waveguide, one or more of the plurality of areas may not be illuminated. However, the waveguide is always operable to illuminate a plurality of areas, even if in some instances it illuminates zero areas or one area.

Reference is made herein to waveguides being arranged to illuminate a plurality of areas. It should be understood that, due to the passive nature of the waveguides and the light splitting elements therein, the waveguides themselves do not perform the illumination. Rather, the waveguide enables illumination of the plurality of areas light through the receipt of light by the waveguide.

Reference is made herein to light and radiation. It should be understood that, while light is a form of radiation, light is used to refer to radiation received by the waveguide and directed to the plurality of areas of the mirror so as to provide heating. On the other hand, the term radiation is used to refer to radiation (e.g. EUV radiation in a radiation beam such as the beam B shown in Figure 1) which is to be reflected by a mirror. Radiation as referred to herein has an additional purpose (e.g. use by a system external to the mirror) but causes indirect heating before being directed to an external system where the radiation is used, whereas light as referred to herein has the primary purpose of heating the mirror and has no significant use external to the mirror.

Features of specific embodiments are not limited to use in that embodiment and features of different embodiments may be combined or removed. For example, the cooling channels, light receiving layer or pre-heating system of Figures 7A-C may be removed, or may be introduced into any other described embodiments. Similarly, any of the mirror systems may be adapted so as to illuminate any areas of the mirror (e.g. in any plane), whether those specifically illustrated herein or any others.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A mirror system, comprising
a mirror; and
a waveguide comprising:
an input configured to receive a light beam from a light source; and
one or more light splitting elements configured to split the light beam into a plurality of beams and direct each of said beams to a respective one of a plurality of outputs, each light splitting element arranged to direct the respective beam to a respective one of a plurality of areas of the mirror.

2. The mirror system of claim 1, wherein the mirror has a front side defined by a radiation facing surface and a back side, and wherein the plurality of areas are located on the back side of the mirror.

3. The mirror system of claim 2, wherein the mirror comprises a first layer and a second layer, the first layer comprising the radiation facing surface.

4. The mirror system of claim 3, wherein the plurality of areas are located at an interface between the first layer and the second layer.

5. The mirror system of claim 3, the second layer further comprising a light receiving layer upon which the plurality of areas are located.

6. The mirror system of any preceding claim, wherein the mirror comprises the waveguide.

7. The mirror system of any of claims 1 to 5, wherein the waveguide is external to the mirror.

8. The mirror system of claim 7, wherein the mirror system further comprises a mirror holder, the mirror holder comprising the waveguide.

9. The mirror system of any preceding claim, wherein the light splitting elements are arranged such that the plurality of areas form a pattern.

10. The mirror system of any preceding claim, wherein the light splitting elements are passive.

11. The mirror system of any preceding claim, wherein at least one of the light splitting elements comprises means of separating light with a specific optical property from the light beam.

12. The mirror system of claim 10, wherein a first light splitting element comprises a first dichroic beamsplitter operable to direct a first range of wavelengths to a first output and a second light splitting element comprises a second dichroic beamsplitter operable to direct a second range of wavelengths different to the first range of wavelengths to a second output.

13. The mirror system of claim 12 comprising multiple first dichroic beamsplitters and multiple second dichroic beamsplitters, wherein the first dichroic beamsplitters are arranged such that a first plurality of areas of the plurality of areas form a first pattern and the second dichroic beamsplitters are arranged such that a second plurality of areas of the plurality of areas form a second pattern.

14. The mirror system of any preceding claim, wherein at least one light splitting element further comprises means to modify its respective beam.

15. The mirror system of any preceding claim, wherein the waveguide is curved.

16. The mirror system of claim 3 or any claim dependent thereon, further comprising means for heating the radiation facing surface.

17. The mirror system of claim 16, further comprising means for decoupling the thermal properties of the front side and back side.

18. The mirror system of any preceding claim, comprising multiple waveguides.

19. The mirror system of claim 18, further comprising means for decoupling thermal properties of a first waveguide of the multiple waveguides and a second waveguide of the multiple waveguides.

20. The mirror system of any preceding claim, wherein the mirror comprises an EUV mirror.

21. The mirror system of any preceding claim, further comprising a light source arranged to provide a light beam to the input of the waveguide.

22. The mirror system of claim 21, wherein the light source is configured to selectively control one or more optical properties of light in the light beam.

23. A lithographic apparatus comprising the mirror system of any preceding claim.

24. A method of controlling deformations of a mirror using the mirror system of claim 22, the method comprising selecting one or more optical properties of the light beam so as to selectively illuminate one or more of a plurality of areas of the mirror.
